# EUROPÄISCHE PATENTANMELDUNG

(11) **EP 4 593 073 A1**
(43) Veröffentlichungstag der Anmeldung: **30.07.2025**
(21) Anmeldenummer: 25153230.5
(22) Anmeldetag: 22.01.2025
(51) Int. Cl.: H01L 21/768, H01L 23/48

(54) **VERTIKALE VERDRAHTUNG EINES HALBLEITERBAUELEMENTS**

(30) Priorität: 24.01.2024 DE 102024200633
(71) Anmelder: Siemens Healthineers AG, 91301 Forchheim (DE); Fraunhofer-Gesellschaft zur Förderung der angewandten Forschung e.V., 80686 München (DE)
(72) Erfinder: Gabiger-Rose, Anna, 90425 Nürnberg (DE); Hosemann, Michael, 91056 Erlangen (DE); Viehweger, Kay, 01990 Ortrand (DE)
(74) Vertreter: Siemens Healthineers Patent Attorneys

(57) **Zusammenfassung**

Es wird ein Verfahren zur Herstellung einer Aussparung für eine Durchkontaktierung in einem Halbleiterbauelement beschrieben. Das Halbleiterbauelement weist ein Halbleitersubstrat auf. Das Halbleiterbauelement umfassend eine erste elektrische Isolationsschicht auf seiner Vorderseite, eine zweite elektrische Isolationsschicht auf der ersten elektrischen Isolationsschicht und eine Kontaktfläche für das Halbleitersubstrat in oder an der zweiten elektrischen Isolationsschicht. Bei dem Verfahren wird eine sacklochartige Aussparung durch das Halbleitersubstrat bis zur ersten elektrischen Isolationsschicht ausgebildet. Die erste elektrische Isolationsschicht wird innerhalb der Aussparung entfernt. Die Aussparung wird in Richtung zu der Kontaktfläche hin durch teilweises Entfernen der zweiten elektrischen Isolationsschicht erweitert. Es wird eine dritte elektrische Isolationsschicht auf Innenwänden der erweiterten Aussparung aufgebracht, wobei die erste elektrische Isolationsschicht zu der erweiterten Aussparung hin abgedeckt wird. Schließlich erfolgt ein anisotropes vertikales Ätzen der zweiten elektrischen Isolationsschicht in Richtung auf die Kontaktfläche hin, bis die Kontaktfläche zum Halbleitersubstrat hin freigelegt ist.

Die Erfindung betrifft ferner ein Verfahren zur Herstellung einer Durchkontaktierung in einem Halbleiterbauelement, ein Halbleiterbauelement und ein Röntgendetektormodul.

## Beschreibung

Die Erfindung betrifft ein Verfahren zur Herstellung einer Aussparung für eine Durchkontaktierung in einem Halbleiterbauelement. Die Erfindung bezieht sich auch auf ein Verfahren zur Herstellung einer Durchkontaktierung in einem Halbleiterbauelement. Weiterhin betrifft die Erfindung ein Halbleiterbauelement. Zudem bezieht sich die Erfindung auf ein Röntgendetektormodul mit einem solchen Halbleiterbauelement.

Ein Röntgendetektor weist eine Mehrzahl von Schichten mit unterschiedlichen Funktionen auf. Zunächst umfasst ein Röntgendetektor eine Sensorschicht mit einem Sensormaterial. Bei einem sogenannten direkt konvertierenden Röntgendetektor werden Röntgenquanten direkt in dem Sensormaterial in elektrische Ladungspulse, deren Gesamtladung ein Maß für die Energie der Röntgenquanten darstellt, umgewandelt. Als Sensormaterial für einen solchen direkt konvertierenden Röntgendetektor wird vorzugsweise Cadmiumtellurid oder Cadmiumzinktellurid eingesetzt. Die Sensorschicht bildet eine aktive Pixelfläche zur Detektion von Röntgenstrahlung. Während einer Röntgenaufnahme entsteht durch die erfassten Röntgenstrahlen in der Sensorschicht ein kontinuierlicher Pulszug.

Die so erzeugten Pulse werden von einer der Sensorschicht nachgeschalteten Zähleinheit, vorzugsweise einem ASIC, in einem einstellbaren Zählintervall gezählt und in ihrer Höhe vermessen. Eine solche Zähleinheit weist eine Mehrzahl von Signalverarbeitungskanälen auf, die in einer speziellen Pixelmatrix angeordnet sind, so genannte Subpixel. Jedes Subpixel soll die Anzahl der Pulse im Pulszug vermessen. Dabei wird die Höhe der Ladungspulse mit einem vorgegebenen Satz von Schwellen verglichen und die korrespondierende Pulsanzahl festgehalten. Unter der Annahme, dass die Absorption eines Röntgenphotons genau einen Ladungspuls auslöst, entspricht die Pulsanzahl der Zahl der absorbierten Röntgenphotonen.

Unter der Annahme, dass die Höhe des Pulses proportional zu der Energie des Röntgenphotons ist, kann ferner die oben erwähnte Schwelle mit einer Energieschwelle gleichgesetzt werden.

Die Schaltkreise bzw. aktiven Schaltungen der Zähleinheit, insbesondere der ASICs, sind auf der Oberseite eines Halbleitersubstrats eines Röntgendetektormoduls, also der Seite des Halbleitersubstrats, welche einer Röntgenquelle zugewandt ist, meist in der sogenannten CMOS-Lage (CMOS steht für "Complementary Metal-Oxid-Semiconductor", zu Deutsch "Komplementärer Metall-Oxid-Halbleiter"), angeordnet. Die aktiven Schaltungen bilden mit dem Halbleitersubstrat eine integrierte Schaltung.

Mit den ASICS bzw. dem Halbleitersubstrat verbunden ist ein Trägersubstrat, welches als Material eine Keramik oder Leiterplattenmaterial aufweisen kann. Durch die Schicht der ASICs sowie durch das Halbleitersubstrat hindurch verlaufen Durchkontaktierungen, welche die von den ASICs erzeugten Zählsignale an das erwähnte Trägersubstrat weiterleiten, in dem eine Umladung von Zählsignalen und eine Verteilung von Steuersignalen und Energieflüssen stattfindet. Im Folgenden wird dieses Trägersubstrat daher auch als Verteileinheit bezeichnet. Von der Verteileinheit aus werden zusammengefasste Signale über Flachbandkabel an eine Auswertungseinheit, auch als "Module Backplane" bezeichnet, weitergeleitet.

Die aktive Pixelfläche eines Röntgendetektors muss möglichst groß sein, um so viel wie möglich von der Röntgenstrahlung, die den Patienten passiert hat, detektieren zu können. Dabei stören Verdrahtungen, die die zur Detektion nutzbare Fläche einschränken. Gleichzeitig müssen die verwendeten Verbindungselemente robust gegen mechanische Belastungen und langzeitstabil sein, ohne die elektrische Leistungsfähigkeit negativ (z.B. durch Widerstände oder Leckströme) zu beeinflussen. Der Prozess zur Fertigung der Verbindungselemente muss mit den zu verbindenden Sensoren und integrierten Schaltkreisen kompatibel sein. Nach jedem Fertigungsschritt muss eine Prüfung der gefertigten Teile erfolgen können. Es sollten Testkontakte mit den ASICS und Sensoren verbindbar sein, um die Sensoren und ASICS bereits während der Herstellung testen zu können.

Werden als Verbindungselemente sogenannte Durchkontaktierungen verwendet, ist es wichtig, dass die Struktur des Sensorchips bzw. des die Zähleinheit tragenden Halbleiterbauelements bei der Ausbildung der Durchkontaktierungen nicht beschädigt wird.

Es ist Aufgabe der Erfindung, einen Herstellungsprozess für ein Halbleiterbauelement und ein solches Halbleiterbauelement, insbesondere ein Röntgendetektormodul mit einem solchen Halbleiterbauelement, zu entwickeln, welche eine Testbarkeit eines solchen Halbleiterbauelements während der Herstellung vereinfachen und effektiver werden lassen.

Diese Aufgabe wird durch ein Verfahren zur Herstellung einer Aussparung für eine Durchkontaktierung in einem Halbleiterbauelement gemäß Patentanspruch 1, durch ein Verfahren zum Herstellen einer Durchkontaktierung in einem Halbleiterbauelement gemäß Patentanspruch 5, durch ein Halbleiterbauelement gemäß Patentanspruch 10 und ein Röntgendetektormodul gemäß Patentanspruch 13 gelöst.

Bei dem erfindungsgemäßen Verfahren zur Herstellung einer Aussparung für eine Durchkontaktierung in einem Halbleiterbauelement wird zunächst als Ausgangsprodukt ein Halbleiterbauelement bereitgestellt. Das Halbleiterbauelement weist bereits eine Mehrzahl von Grundelementen auf, die als Träger von elektronischen Schaltungen, zur Vermeidung von Kurzschlussströmen und für einen Test der elektronischen Schaltungen ausgebildet sind.

Diese Grundelemente umfassen ein Halbleitersubstrat mit einer Rückseite und einer Vorderseite. Die beiden genannten Seiten werden dabei durch die beiden Flachseiten des Halbleitersubstrats gebildet. Auf der Vorderseite des Halbleitersubstrats ist eine erste elektrische Isolationsschicht ausgebildet. Eine zweite elektrische Isolationsschicht ist auf der ersten elektrischen Isolationsschicht angeordnet.

Das Halbleiterbauelement umfasst auch eine Kontaktfläche für das Halbleitersubstrat in oder an der zweiten elektrischen Isolationsschicht und vorzugsweise einen Testkontakt auf der Kontaktfläche.

Im Rahmen des erfindungsgemäßen Verfahrens wird zunächst eine sacklochartige Aussparung durch das Halbleitersubstrat hindurch bis zur ersten elektrischen Isolationsschicht erstellt bzw. ausgebildet. Innerhalb der sacklochartigen Aussparung wird die erste elektrische Isolationsschicht entfernt. Die Aussparung wird in vertikaler Richtung, d.h. quer zu der Kontaktfläche und zur Kontaktfläche hin, vorzugsweise durch teilweises Entfernen der zweiten elektrischen Isolationsschicht erweitert. Weiterhin wird eine dritte elektrische Isolationsschicht auf Innenwänden der erweiterten Aussparung aufgebracht, wobei die erste elektrische Isolationsschicht zu der erweiterten Aussparung hin abgedeckt wird. Schließlich erfolgt ein anisotropes vertikales Ätzen, d.h. quer zu der Schichtfolge, der zweiten elektrischen Isolationsschicht, bis die Kontaktfläche zum Halbleitersubstrat hin freigelegt ist und die Aussparung für die Durchkontaktierung somit vollständig ausgebildet ist. Bei dem anisotropen Ätzen werden die zweite elektrische Isolationsschicht und die dritte elektrische Isolationsschicht vollständig von der Kontaktfläche entfernt. Vorteilhaft wird die erste elektrische Isolationsschicht durch die dritte elektrische Isolationsschicht gegen eine Beschädigung bei dem anisotropen Ätzen geschützt. Denn es ist oft möglich, dass ohne einen geeigneten Schutz bei dem anisotropen Ätzen die erste elektrische Isolationsschicht geschädigt wird, was zu einem Defekt bzw. verschlechterten funktionellen Eigenschaften des Halbleiterbauelements beitragen kann. Insbesondere sollen bei dem anisotropen Ätzschritt seitliche Einätzungen in die erste elektrische Isolationsschicht vermieden werden. Denn solche Einätzungen können Ausgangspunkte für mechanische Risse in dem Halbleiterbauelement darstellen. Der Schutz der ersten elektrischen Isolationsschicht ist besonders dann effektiv und sinnvoll, wenn das Material der ersten elektrischen Isolationsschicht besonders empfindlich auf den anisotropen Ätzschritt reagiert, wohingegen das Material der zweiten und dritten elektrischen Isolationsschicht, welches sich vorzugsweise von dem Material der ersten elektrischen Isolationsschicht unterscheidet, relativ robust gegenüber dem anisotropen Ätzen reagiert, insbesondere was das seitliche Unterätzen der jeweiligen Schicht betrifft. Es ist anzumerken, dass die Aussparung für eine Durchkontaktierung nicht auf die Anwendung auf Halbleitersubstrate von Röntgendetektormodulen beschränkt ist, sondern auch bei anderen Sensorbauelementen, wie zum Beispiel auf Pixelbasis arbeitenden Sensorbauelementen von optischen Bildaufnahmeeinheiten, Anwendung finden kann.

Bei dem erfindungsgemäßen Verfahren zur Herstellung einer Durchkontaktierung in einem Halbleiterbauelement wird das erfindungsgemäße Verfahren zur Herstellung einer Aussparung für eine Durchkontaktierung in einem Halbleiterbauelement durchgeführt. Weiterhin wird eine Barriereschicht auf einer von der ersten elektrischen Isolationsschicht wegweisenden Oberfläche der dritten elektrischen Isolationsschicht und auf der Kontaktfläche in der Aussparung aufgebracht. Vorzugsweise wird die Aussparung mit der Barriereschicht vollständig ausgekleidet. Die Barriereschicht verhindert ein Eindiffundieren von Leitermaterial, welches bei dem nachfolgenden Schritt aufgebracht werden soll, in darunterliegende Schichten und Bereiche.

Nachfolgend wird eine Leiterbahn auf dem Halbleitersubstrat und in der Aussparung auf der Barriereschicht aufgebracht. Die Leiterbahn bildet eine elektrische Verbindung zwischen der Rückseite des Halbleitersubstrats und der Kontaktfläche des Halbleiterbauelements.

Auf der Leiterbahn wird anschließend eine erste rückseitige Passivierungsschicht aufgebracht. Die Passivierungsschicht schützt die Leiterbahn vor Korrosion.

Auf der Leiterbahn wird ein Kontaktelement aufgebracht, welches einen elektrischen Kontakt des Halbleiterbauelements zu einem benachbarten elektronischen Bauelement, vorzugsweise einer Sensoreinheit eines Röntgendetektormoduls, ausbildet. Das Kontaktelement weist bevorzugt als Material Gold auf, welches elektrisch leitfähig und sehr korrosionsbeständig ist. Das Verfahren zur Herstellung einer Durchkontaktierung in einem Halbleiterbauelement teilt die Vorteile des Verfahrens zur Herstellung einer Aussparung für eine Durchkontaktierung in einem Halbleiterbauelement.

Das erfindungsgemäße Halbleiterbauelement weist ein Halbleitersubstrat mit einer Rückseite und einer Vorderseite auf. Wie bereits erläutert, werden die beiden genannten Seiten dabei durch die beiden Flachseiten des Halbleitersubstrats gebildet. Das Halbleiterbauelement weist eine erste elektrische Isolationsschicht auf dem Halbleitersubstrat und eine zweite elektrische Isolationsschicht auf der ersten elektrischen Isolationsschicht auf. Weiterhin umfasst das Halbleiterbauelement eine Kontaktfläche für das Halbleitersubstrat an oder in der zweiten elektrischen Isolationsschicht. Das erfindungsgemäße Halbleiterbauelement weist eine Aussparung für eine Durchkontaktierung zwischen dem Halbleitersubstrat und der Kontaktfläche auf. Die Aussparung reicht bis zu der Kontaktfläche hin. Weiterhin ist eine dritte elektrische Isolationsschicht auf Innenwänden der Aussparung ausgebildet, wobei die erste elektrische Isolationsschicht zu der Aussparung hin durch die dritte elektrische Isolationsschicht abgedeckt ist.

Das erfindungsgemäße Röntgendetektormodul weist eine Sensoreinheit und ein erfindungsgemäßes Halbleiterbauelement auf. Das Halbleitersubstrat des Halbleiterbauelements weist eine Zählelektronik auf, welche mit dem Halbleiterbauelement elektrisch verbunden ist. Das erfindungsgemäße Röntgendetektormodul weist auch eine Verteilungseinheit auf, welche mit dem erfindungsgemäßen Halbleiterbauelement elektrisch verbunden ist. Das Röntgendetektormodul umfasst zudem eine Auswertungseinheit, welche, vorzugsweise durch ein oder mehrere Flachkabel, mit der Verteilungseinheit elektrisch verbunden ist. Das Röntgendetektormodul teilt die Vorteile des erfindungsgemäßen Halbleiterbauelements.

Die Erfindung umfasst auch eine Steuereinrichtung zur Steuerung der Schritte zum Ausführen des erfindungsgemäßen Verfahrens zur Herstellung einer Aussparung für eine Durchkontaktierung in einem Halbleiterbauelement und des erfindungsgemäßen Verfahrens zum Herstellen einer Durchkontaktierung in einem Halbleiterbauelement. Die Steuereinrichtung kann insbesondere eine Halbleiterproduktionseinrichtung ansteuern, um die Schritte des erfindungsgemäßen Verfahrens zur Herstellung einer Aussparung für eine Durchkontaktierung in einem Halbleiterbauelement oder des erfindungsgemäßen Verfahrens zur Herstellung einer Durchkontaktierung in einem Halbleiterbauelement auszuführen.

Ein Großteil der zuvor genannten Steuereinrichtung zur Steuerung der Schritte des erfindungsgemäßen Verfahrens zur Herstellung einer Aussparung für eine Durchkontaktierung in einem Halbleiterbauelement und des erfindungsgemäßen Verfahrens zur Herstellung einer Durchkontaktierung in einem Halbleiterbauelement kann ganz oder teilweise in Form von Softwaremodulen in einem Prozessor eines entsprechenden Rechensystems realisiert werden, z. B. von einer Steuereinrichtung einer Einrichtung zur Herstellung eines Halbleiterbauelements bzw. einer Halbleiterproduktionseinrichtung. Eine weitgehend softwaremäßige Realisierung hat den Vorteil, dass auch schon bisher verwendete Rechensysteme zur Produktionssteuerung von Halbleiterbauelementen auf einfache Weise durch ein Software-Update nachgerüstet werden können, um auf die erfindungsgemäße Weise zu arbeiten. Insofern wird die Aufgabe auch durch ein entsprechendes Computerprogrammprodukt mit einem Computerprogramm gelöst, welches direkt in ein Rechensystem ladbar ist, mit Programmabschnitten, um Steuerungsvorgänge zur Umsetzung der Schritte des erfindungsgemäßen Verfahrens zur Herstellung einer Aussparung für eine Durchkontaktierung in einem Halbleiterbauelement oder des Verfahrens zur Herstellung einer Durchkontaktierung in einem Halbleiterbauelement auszuführen. Ein solches Computerprogrammprodukt kann neben dem Computerprogramm gegebenenfalls zusätzliche Bestandteile wie z. B. eine Dokumentation und/oder zusätzliche Komponenten, auch Hardware-Komponenten, wie z.B. Hardware-Schlüssel (Dongles etc.) zur Nutzung der Software, umfassen.

Zum Transport zum Rechensystem bzw. zur Steuereinrichtung und/oder zur Speicherung an oder in dem Rechensystem bzw. der Steuereinrichtung kann ein computerlesbares Medium, z. B. ein Memorystick, eine Festplatte oder ein sonstiger transportabler oder fest eingebauter Datenträger dienen, auf welchem die von einem Rechensystem einlesbaren und ausführbaren Programmabschnitte des Computerprogramms gespeichert sind. Das Rechensystem kann z. B. hierzu einen oder mehrere zusammenarbeitende Mikroprozessoren oder dergleichen aufweisen.

Die abhängigen Ansprüche sowie die nachfolgende Beschreibung enthalten jeweils besonders vorteilhafte Ausgestaltungen und Weiterbildungen der Erfindung. Dabei können insbesondere die Ansprüche einer Anspruchskategorie auch analog zu den abhängigen Ansprüchen einer anderen Anspruchskategorie weitergebildet sein. Zudem können im Rahmen der Erfindung die verschiedenen Merkmale unterschiedlicher Ausführungsbeispiele und Ansprüche auch zu neuen Ausführungsbeispielen kombiniert werden.

In einer bevorzugten Variante des erfindungsgemäßen Verfahrens zur Herstellung einer Aussparung für eine Durchkontaktierung in einem Halbleiterbauelement umfasst die erste elektrische Isolationsschicht Siliziumnitrid und umfasst die zweite und die dritte elektrische Isolationsschicht Siliziumdioxid. Siliziumnitrid kann zum Beispiel als Maskierungs- und Stoppmaterial bei der Strukturierung des Halbleitersubstrats eingesetzt werden.

Bevorzugt weist die Leiterbahn eines der folgenden Materialien auf:
- Kupfer,
- Aluminium,
- Wolfram.

Kupfer weist mit 58 MS/m (MS = Mega-Siemens) die beste Leitfähigkeit unter den drei genannten Materialien auf. Wolfram ist besonders widerstandsfähig. Aluminium ist vergleichsweise kostengünstig und neigt nicht zur Diffusion in das Substratmaterial. Wolfram kann als Kontaktmaterial zwischen Aluminiumleiterbahnen und Leitungen aus anderem Material genutzt werden.

Besonders bevorzugt weist die erste rückseitige Passivierungsschicht eines der folgenden Materialien auf:
- Nickel,
- Siliziumdioxid,
- Polyimid.

Nickel ist ein elektrischer Leiter. Siliziumdioxid und Bleioxid sind elektrische Isolatoren. Polyimide sind chemisch beständig und hitzebeständig. Polyimide werden in der Elektrotechnik wegen ihrer Hitzebeständigkeit, geringen Ausgasung, Strahlungsbeständigkeit und ihrer Isoliereigenschaften verwendet.

In einer Ausgestaltung des erfindungsgemäßen Verfahrens zur Herstellung einer Durchkontaktierung in einem Halbleiterbauelement wird die Rückseite des Halbleitersubstrats strukturiert und wird mit einer zweiten rückseitigen Passivierungsschicht auf der dritten elektrischen Isolationsschicht und auf der Leiterbahn versehen. Vorteilhaft werden nicht zur Kontaktierung genutzte Bereiche der Rückseite des Halbleitersubstrats isoliert und gegen Korrosion geschützt.

Bevorzugt umfasst die zweite rückseitige Passivierungsschicht eines der folgenden Materialien:
- Polyimid,
- Siliziumnitrid,
- Siliziumdioxid.

Die genannten Materialien sind elektrische Isolatoren und relativ beständig und schützen den nicht zur Kontaktierung genutzten Teil der Rückseite des Halbleitersubstrats gegen Korrosion und Leckströme.

Das Halbleiterbauelement kann einen Testkontakt in Kontakt, insbesondere in direktem physischen Kontakt, mit der Kontaktfläche aufweisen. Der Testkontakt kann vorteilhaft zu Testzwecken von einer Testeinrichtung elektrisch kontaktiert werden. Vorteilhaft kann das Halbleiterbauelement und/oder Elemente davon hinsichtlich ihrer Funktionsfähigkeit über den Testkontakt getestet werden.

Der Testkontakt weist ein elektrisch leitendes Material auf. Insbesondere kann der Testkontakt Kupfer, Nickel, Palladium oder Gold oder eine Kombination davon in Schichten und/oder als Metalllegierung aufweisen. Er kann jedoch auch ein anderes elektrisch leitendes Material aufweisen. Insbesondere kann der Testkontakt ein anderes Material oder eine andere Materialkombination aufweisen als die Kontaktfläche. Beispielsweise weist die Kontaktfläche Kupfer und Aluminium auf. Beispielsweise weist der Testkontakt Kupfer und Gold auf. Vorteilhaft weist der Testkontakt eine hohe elektrische Leitfähigkeit und gute Kontaktierbarkeit auf. Insbesondere kann der Testkontakt als massive Struktur ausgebildet sein. In diesem Fall kann der Testkontakt insbesondere ohne zwischenliegende isolierende Schichten ausgebildet sein.

Der Testkontakt kann im Wesentlichen mit der flächigen Ausdehnung der Kontaktfläche überlappend angeordnet sein. Die flächige Ausdehnung des Testkontakts kann mit der flächigen Ausdehnung der Kontaktfläche im Wesentlichen übereinstimmen. Sie kann jedoch auch kleiner oder größer sein. Insbesondere kann die flächige Ausdehnung des Testkontakts zumindest zum Großteil die flächige Ausdehnung der Kontaktfläche überstrecken. Vorteilhaft kann eine Kombination aus der TSV Kontaktfläche und darüberliegendem Testkontakt den Platzbedarf beschränken, ohne auf die Möglichkeit einer Testkontaktierung zu verzichten. Derart kann verhindert werden, dass Chipfläche nicht für sonstige Funktionen, wie beispielsweise aktive Schaltungen, genutzt werden kann. Die Form der Kontaktfläche und des Testkontakts kann dabei gleichartig oder auch unterschiedlich gewählt sein.

Der Testkontakt kann eine insgesamte Materialstärke, d.h. eine Ausdehnung des Testkontakts senkrecht zur Halbleitervorderseite, aufweisen, welche größer ist als die Materialstärke der Kontaktfläche. Dabei kann die Kontaktfläche in Schichten umfassend Metallschichten und Schichten umfassend ein isolierendes Material, aufgebaut sein. Weist die Kontaktfläche mehrere Metallschichten auf, so kann der Testkontakt insbesondere stärker ausgebildet sein als jede der Metallschichten der Kontaktfläche. Insbesondere kann die insgesamte Materialdicke des Testkontakts größer sein als die insgesamte, d.h. alle Schichten umfassende, Materialdicke der Kontaktfläche. Der Testkontakt kann etwa 1,5 bis 3 mal stärker ausgebildet sein als die insgesamte Materialstärke der Kontaktfläche. Beispielsweise ist der Testkontakt doppelt so stark ausgebildet. Vorteilhaft verstärkt das Material des Testkontakts die Struktur bzw. den Bereich über der Aussparung für die Durchkontaktierung und macht diese bzw. diesen mechanisch robuster. Derart kann eine Durchkontaktierung und insbesondere auch eine Mehrzahl an Durchkontaktierungen in einem Halbeleiterelement bereitgestellt werden, wobei gleichzeitig vorteilhaft ein mechanisch stabiles und bruchunanfälliges Halbleiterelement während und/oder nach der Ausbildung der Aussparungen gewährleistet wird. Insbesondere kann der Testkontakt dabei als massives Element aus einem bzw. einer Kombination von elektrisch leitenden Materialien ausgebildet sein, so dass eine besonders vorteilhafte Robustheit gewährleistet ist.

Weiterhin kann auf der Vorderseite des Halbleiterbauelements eine Passivierungsschicht aufgetragen sein, beispielsweise aus Polyimid oder Bleioxid, welche den Testkontakt ausspart.

Die Erfindung wird im Folgenden unter Hinweis auf die beigefügten Figuren anhand von Ausführungsbeispielen noch einmal näher erläutert. Es zeigen:
- FIG 1: eine schematische Darstellung eines Röntgendetektormoduls,
- FIG 2: eine schematische Darstellung eines Halbleiterbauelements, welches als Substrat für eine Zähleinheit eines Röntgendetektormoduls genutzt wird,
- FIG 3: eine schematische Darstellung eines Schritts zum Ätzen einer sacklochartigen Aussparung in einem Halbleiterbauelement im Rahmen des Verfahrens zur Herstellung einer Aussparung für eine Durchkontaktierung in einem Halbleiterbauelement gemäß einem Ausführungsbeispiel der Erfindung,
- FIG 4: eine schematische Darstellung eines Schritts zum Entfernen einer ersten elektrischen Isolationsschicht im Bereich der Aussparung im Rahmen des Verfahrens zur Herstellung einer Aussparung für eine Durchkontaktierung in einem Halbleiterbauelement gemäß einem Ausführungsbeispiel der Erfindung,
- FIG 5: eine schematische Darstellung eines Schritts zum Aufbringen einer dritten elektrischen Isolationsschicht im Rahmen des Verfahrens zur Herstellung einer Aussparung für eine Durchkontaktierung in einem Halbleiterbauelement gemäß einem Ausführungsbeispiel der Erfindung,
- FIG 6: eine schematische Darstellung eines Schritts zum anisotropen vertikalen Ätzen der zweiten elektrischen Isolationsschicht bis zur Freilegung des Testkontakts im Rahmen des Verfahrens zur Herstellung einer Aussparung für eine Durchkontaktierung in einem Halbleiterbauelement gemäß einem Ausführungsbeispiel der Erfindung,
- FIG 7: eine schematische Darstellung eines Schritts zum Aufbringen einer Barriereschicht auf der Oberfläche der dritten elektrischen Isolationsschicht und auf dem Testkontakt in der Aussparung im Rahmen des Verfahrens zur Herstellung einer Durchkontaktierung in einem Halbleiterbauelement gemäß einem Ausführungsbeispiel der Erfindung,
- FIG 8: eine schematische Darstellung des Schritts zum Aufbringen einer Leiterbahn auf einem Halbleitersubstrat und in der Aussparung auf der Barriereschicht im Rahmen des Verfahrens zur Herstellung einer Durchkontaktierung in einem Halbleiterbauelement gemäß einem Ausführungsbeispiel der Erfindung,
- FIG 9: eine schematische Darstellung des Schritts zum Aufbringen einer ersten rückseitigen Passivierungsschicht auf der Leiterbahn im Rahmen des Verfahrens zur Herstellung einer Durchkontaktierung in einem Halbleiterbauelement gemäß einem Ausführungsbeispiel der Erfindung,
- FIG 10: eine schematische Darstellung des Schritts zum Strukturieren der Rückseite des Halbleitersubstrats im Rahmen des Verfahrens zur Herstellung einer Durchkontaktierung in einem Halbleiterbauelement gemäß einem Ausführungsbeispiel der Erfindung,
- FIG 11: eine schematische Darstellung zum Aufbringen von Kontaktelementen auf der Rückseite des Halbleitersubstrats im Rahmen des Verfahrens zur Herstellung einer Durchkontaktierung in einem Halbleiterbauelement gemäß einem Ausführungsbeispiel der Erfindung,
- FIG 12: ein Flussdiagramm, welches ein Verfahren zur Herstellung einer Durchkontaktierung in einem Halbleiterbauelement gemäß einem Ausführungsbeispiel der Erfindung veranschaulicht.

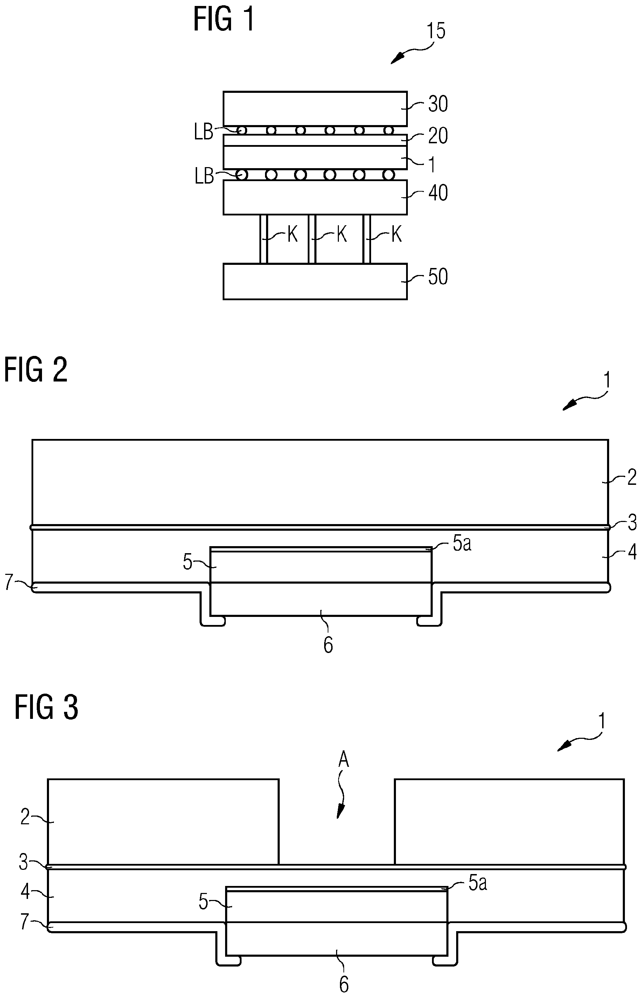

In FIG 1 ist eine schematische Darstellung eines direktkonvertierenden Röntgendetektormoduls 15 veranschaulicht. Ein solches Röntgendetektormodul 15 weist eine Sensoreinheit 30 mit einer Mehrzahl von Sensoren auf, welche zum Beispiel Cadmiumtellurid als Sensormaterial aufweisen. Die Sensoreinheit 30 ist über sogenannte Lötbälle LB mit einem Halbleiterbauelement 1 verbunden, welches eine Zähleinheit 20 umfasst, welche auf der der Sensoreinheit 30 zugewandten Seite des Halbleiterbauelements 1 (auch als Rückseite bezeichnet) ausgebildet ist und eine Mehrzahl von elektronischen Schaltungen, sogenannte ASICs (ASIC ist ein Akronym für "applicationspecific integrated circuit", zu Deutsch "Anwendungsspezifische integrierte Schaltung") aufweist. Die ASICs (in FIG 1 nicht gezeigt) sind über Durchkontaktierungen mit der Unterseite des Halbleiterbauelements 1 elektrisch verbunden.

Das Röntgendetektormodul 15 weist auch eine Verteilungseinheit 40 auf, welche ein Keramikmaterial umfasst und Leitungen zur Spannungsversorgung der ASICs in dem Halbleiterbauelement 1 und zur Signalverteilung aufweist. Die Verteilungseinheit 40 ist mit dem Halbleiterbauelement 1 über Lötbälle LB elektrisch verbunden.

Teil des Röntgendetektormoduls 15 ist auch eine Auswertungseinheit 50, welche eine von den vorgenannten Einheiten 1, 30, 40 räumlich getrennte modulare Rückverdrahtung umfasst. Die Auswertungseinheit 50 ist über Flachbandkabel K mit der Verteilungseinheit 40 elektrisch verbunden, liefert über die Flachbandkabel K elektrische Energie und Steuerdaten und von der Sensoreinheit 30 und der Zähleinheit 20 generierte Signaldaten.

In FIG 2 ist eine schematische Darstellung einer Ausgangsstufe eines Halbleiterbauelements 1 gezeigt, welches zum Beispiel in einem Röntgendetektormodul 15 als Träger einer Zähleinheit 20 eines Röntgendetektormoduls 15, welcher in FIG 1 gezeigt ist, genutzt werden kann. Das Halbleiterbauelement 1 weist ein Halbleitersubstrat 2 mit einer Vorderseite und einer Rückseite auf. Als Rückseite soll die in FIG 2 gezeigte Oberseite des Halbleitersubstrats 2 gelten und als Vorderseite die Unterseite. Mit dem Halbleitersubstrat 2 verbunden ist eine erste schmale elektrische Isolationsschicht 3 auf der Vorderseite des Halbleitersubstrats 2. Die erste elektrische Isolationsschicht 3 umfasst beispielsweise Siliziumnitrid. Mit der ersten elektrischen Isolationsschicht 3 ist eine zweite breite elektrische Isolationsschicht 4 verbunden. Die zweite elektrische Isolationsschicht 4 umfasst beispielsweise Siliziumdioxid als Isolationsmaterial. In die zweite elektrische Isolationsschicht 4 integriert ist eine Kontaktfläche 5 in Form eines sogenannten Landing-Pads. Die Kontaktfläche 5 bzw. das Landing-Pad kann dabei auch in Schichten umfassend eine Anzahl an Metallschichten und dazwischenliegenden Schichten umfassend isolierendes Material aufgebaut sein. Das Landing-Pad bietet einen elektrischen Anschluss mit auf der Rückseite des Halbleitersubstrats 2 befindlichen elektronischen Schaltungen (nicht gezeigt). Allerdings muss hierfür eine Durchkontaktierung von der Rückseite des Halbleitersubstrats 2 bis zu der Kontaktfläche 5 geschaffen werden, was in FIG 3 bis FIG 11 ausführlich veranschaulicht ist. Auf der Rückseite der Kontaktfläche 5 bzw. des Landing-Pads, also auf der der zweiten elektrischen Isolationsschicht 4 zugewandten Seite der Kontaktfläche 5 befindet sich eine elektrisch leitende Barriereschicht 5a, welche zum Beispiel aus Titan, Titannitrid oder Wolfram hergestellt sein kann. Eine solche Barriereschicht 5a kann zum Beispiel als Ätzstoppschicht und Schutzschicht bei den nachfolgenden Schritten zur Ausbildung einer Durchkontaktierung eingesetzt werden, um insbesondere das Metall der Kontaktfläche 5 bzw. des Landing-Pads, beispielsweise Kupfer oder Aluminium, zu schützen. Das Landing-Pad bzw. die Kontaktfläche 5 ist mit einem Testkontakt 6 verbunden. Dieser kann zu Testzwecken von einer Testeinrichtung (nicht gezeigt) aus elektrisch kontaktiert werden. Der Testkontakt 6 ist überlappend mit der flächigen Ausdehnung der Kontaktfläche 5 bzw. des Landing-Pads angeordnet. Insbesondere ist der Testkontakt 6 direkt über der Kontaktfläche 5 bzw. dem Landing-Pad ausgebildet. Insbesondere kann, wie hier in Fig. 2 dargestellt, die flächige Ausdehnung des Testkontakts 6 mit der flächigen Ausdehnung der Kontaktfläche 5 bzw. des Landing-Pads im Wesentlichen übereinstimmen. Sie kann jedoch auch kleiner oder größer sein. Der Testkontakt 6 weist ein elektrisch leitendes Material, beispielsweise Kupfer, Nickel, Palladium oder Gold, oder Kombinationen als Metalllegierung oder in Schichten auf. Der Testkontakt 6 umfasst beispielsweise Metallverbindungen aus Kupfer und Nickel oder Palladium oder Gold. Insbesondere kann der Testkontakt 6 als massive Struktur ausgebildet sein. Über den Testkontakt 6 können die auf der Rückseite des Halbleitersubstrats 2 befindlichen elektronischen Schaltungen (nicht gezeigt) getestet werden. Auf der Vorderseite des Halbleiterbauelements 1 ist eine Passivierungsschicht 7 aufgetragen, welche beispielsweise aus Polyimid oder Bleioxid ausgestaltet ist und den Testkontakt 6 ausspart, damit eine elektrische Kontaktierung des Testkontakts durch eine Testeinrichtung weiterhin möglich ist.

Die Materialstärke des Testkontakts 6, d.h. eine Ausdehnung des Testkontakts 6 senkrecht zur Halbleitervorderseite kann in vorteilhaften Varianten dabei insbesondere auch größer sein als die Materialstärke der Kontaktfläche 5. Weist die Kontaktfläche 5 mehrere Metallschichten auf, so ist der Testkontakt 6 insbesondere stärker ausgebildet als jede der Metallschichten der Kontaktfläche 5. Insbesondere kann jedoch die insgesamte Materialstärke des Testkontakts 6 größer sein als die insgesamte, d.h. alle Schichten umfassende, Materialstärke der Kontaktfläche 5. Durch das Material des Testkontakts 6 wird die Struktur bzw. den Bereich über der Aussparung A für die Durchkontaktierung verstärkt und macht diese bzw. diesen mechanisch robuster.

In FIG 3 ist eine schematische Darstellung eines Schritts zum Ätzen einer sacklochartigen Aussparung A in einem Halbleiterbauelement 1 im Rahmen des Verfahrens zur Herstellung einer Aussparung A" für eine Durchkontaktierung in einem Halbleiterbauelement 1 gemäß einem Ausführungsbeispiel der Erfindung veranschaulicht. Die sacklochartige Aussparung A wird an einer Stelle im Halbleitersubstrat 2 des Halbeiterbauelements 1 positioniert, an der eine Durchkontaktierung als elektrische Verbindung zwischen auf der Rückseite des Halbeitersubstrats 2 befindlichen elektronischen Schaltungen und dem Landing-Pad bzw. der Kontaktfläche 5 ausgebildet werden soll.

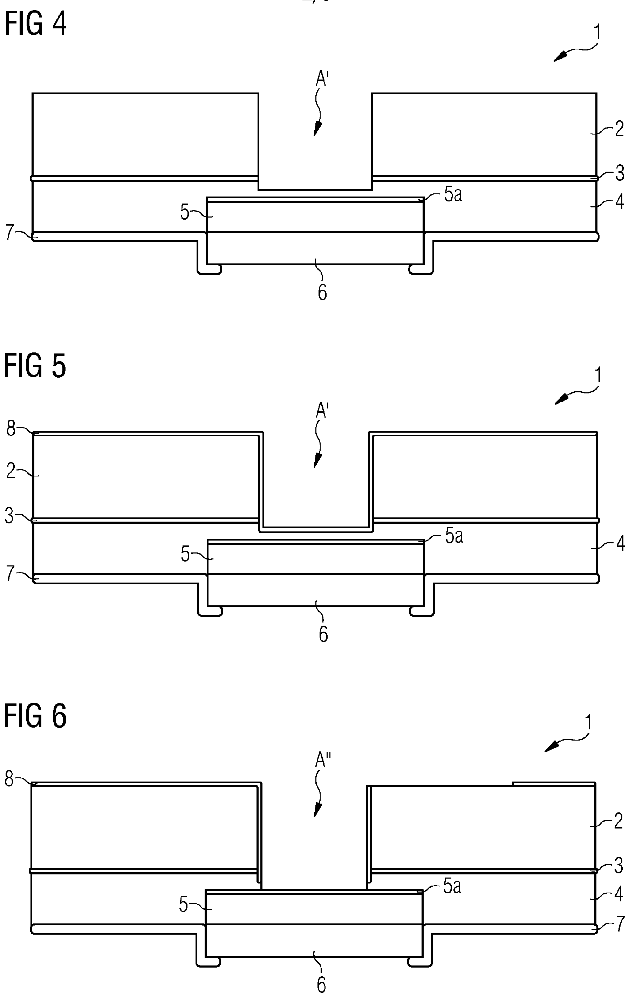

In FIG 4 ist eine schematische Darstellung eines Schritts zum Entfernen der ersten elektrischen Isolationsschicht 3 im Bereich der Aussparung A im Rahmen des Verfahrens zur Herstellung einer Aussparung A" für eine Durchkontaktierung in einem Halbleiterbauelement 1 gemäß einem Ausführungsbeispiel der Erfindung veranschaulicht. Bei dem in FIG 4 gezeigten Schritt wird anschaulich gesprochen der Boden des bei dem in FIG 3 gezeigten Schritt erzeugten Sacklochs bzw. der sacklochartigen Aussparung A, welcher von der ersten elektrischen Isolationsschicht 3 gebildet wird, durch Ätzen entfernt. Weiterhin wird auch die zweite elektrische Isolationsschicht 4 etwas angeätzt, jedoch nicht vollständig, also insbesondere nicht bis zu der Barriereschicht 5a, welche die zweite elektrische Isolationsschicht 4 von dem Landing-Pad bzw. der Kontaktfläche 5 trennt.

In FIG 5 ist eine schematische Darstellung eines Schritts zum Aufbringen einer dritten elektrischen Isolationsschicht 8 im Rahmen des Verfahrens zur Herstellung einer Aussparung A" für eine Durchkontaktierung in einem Halbleiterbauelement 1 gemäß einem Ausführungsbeispiel der Erfindung veranschaulicht. Die dritte elektrische Isolationsschicht 8 wird sowohl in das erweiterte Sackloch der vertieften Aussparung A' eingebracht als auch auf der Rückseite des Halbleitersubstrats 2 ausgebildet. Die dritte elektrische Isolationsschicht 8 umfasst Siliziumdioxid oder Kunststoffe als Material und deckt insbesondere die erste elektrische Isolationsschicht 3 zu der vertieften Aussparung A' hin ab, damit bei dem nächsten Ätzschritt, der in FIG 6 veranschaulicht ist, die erste elektrische Isolationsschicht 3 nicht in horizontaler Richtung angeätzt wird, was zu Rissen in dem Halbleiterbauelement 1 und zu Kurzschlüssen oder Fehlfunktionen von in dem Halbleiterbauelement 1 befindlichen elektronischen Schaltungen führen könnte.

In FIG 6 ist eine schematische Darstellung eines Schritts zum anisotropen vertikalen Ätzen der zweiten elektrischen Isolationsschicht 4 bis zur Freilegung der auf der Kontaktfläche 5 befindlichen Barriereschicht 5a im Rahmen des Verfahrens zur Herstellung einer Aussparung A" in einem Halbleiterbauelement 1 gemäß einem Ausführungsbeispiel der Erfindung veranschaulicht. Anisotropes Ätzen kann zum Beispiel unter Ausnutzung einer Orientierung einer Kristallstruktur eines Materials realisiert werden. Jedenfalls erfolgt ein gerichtetes Ätzen in vertikaler Richtung, also in Richtung der Schichtfolge bis zu der Barriereschicht 5a hin. Durch das anisotrope Ätzen bis zur Barriereschicht 5a wird die Aussparung A", welche für die Ausbildung einer Durchkontaktierung benötigt wird, in dem Halbleiterbauelement 1 vollständig ausgebildet.

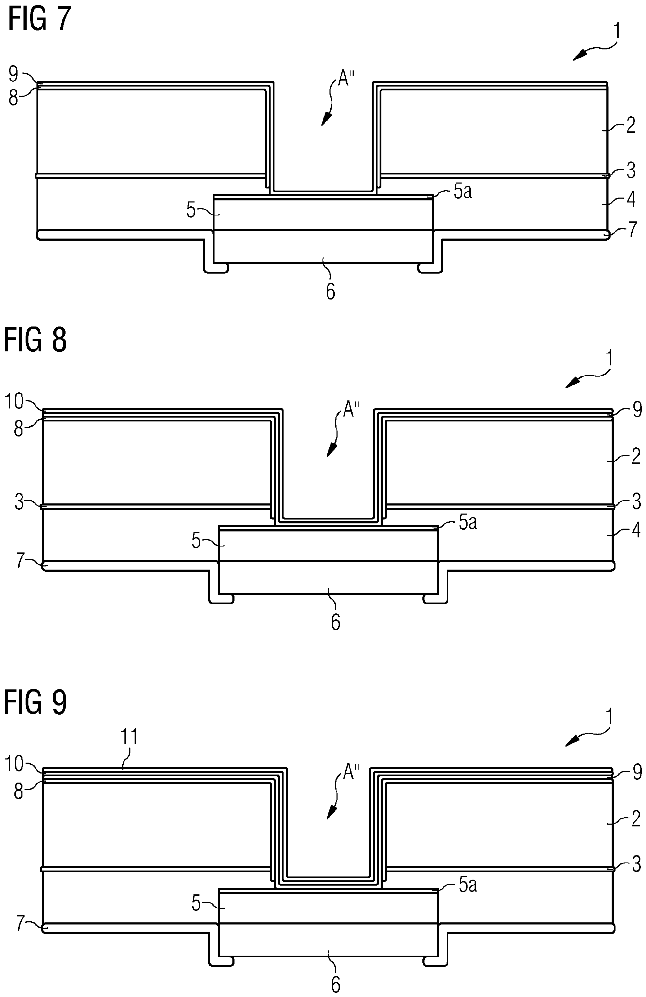

In FIG 7 ist eine schematische Darstellung eines Schritts zum Aufbringen einer Barriereschicht 9 auf der Oberfläche der dritten elektrischen Isolationsschicht 8 und auf der Barriereschicht 5a in der Aussparung im Rahmen des Verfahrens zur Herstellung einer Durchkontaktierung in einem Halbleiterbauelement gemäß einem Ausführungsbeispiel der Erfindung veranschaulicht. Die Barriereschicht 9 umfasst als Material beispielsweise Titan oder Wolfram. Die Barriereschicht 9 verhindert, dass anschließend aufgebrachte Leitermaterialien in die dritte elektrische Isolationsschicht 8 eindringen.

In FIG 8 ist eine schematische Darstellung des Schritts zum Aufbringen einer Leiterbahn 10 auf dem Halbleitersubstrat 2 und in der Aussparung A" auf der Barriereschicht 9 im Rahmen des Verfahrens zur Herstellung einer Durchkontaktierung in einem Halbleiterbauelement 1 gemäß einem Ausführungsbeispiel der Erfindung veranschaulicht. Die Leiterbahn 10 kann zum Beispiel elektrisch gut leitende Materialien wie Kupfer, Aluminium oder Wolfram umfassen und ein- oder zweilagig ausgebildet sein.

In FIG 9 ist eine schematische Darstellung des Schritts zum Aufbringen einer ersten rückseitigen Passivierungsschicht 11 auf der Leiterbahn 10 im Rahmen des Verfahrens zur Herstellung einer Durchkontaktierung in einem Halbleiterbauelement 1 gemäß einem Ausführungsbeispiel der Erfindung veranschaulicht. Die Passivierungsschicht 11 schützt das Material der Leiterbahn 10 vor Korrosion.

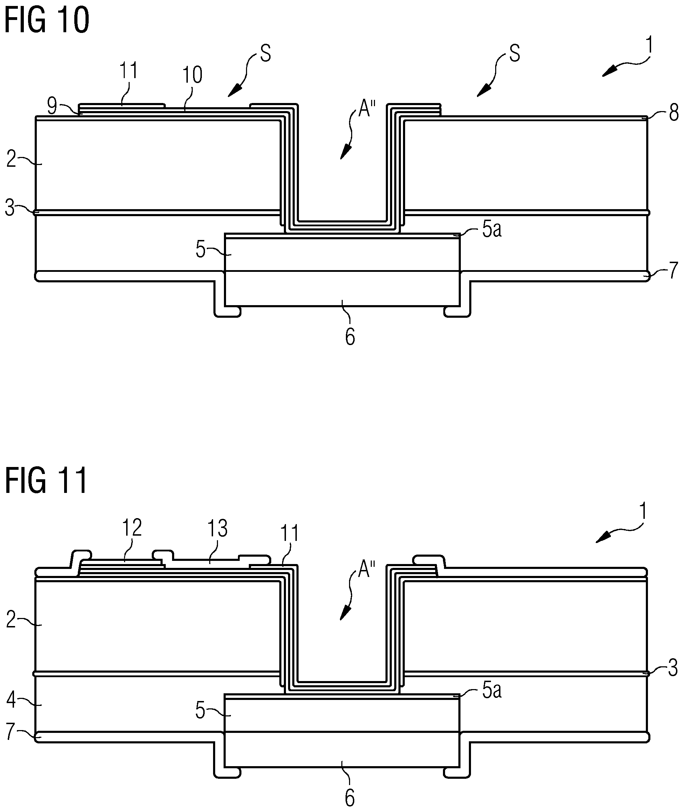

In FIG 10 ist eine schematische Darstellung des Schritts zum Strukturieren der Rückseite des Halbleitersubstrats 2 im Rahmen des Verfahrens zur Herstellung einer Durchkontaktierung in einem Halbleiterbauelement gemäß einem Ausführungsbeispiel der Erfindung veranschaulicht. Das Strukturieren der Rückseite des Halbleitersubstrats 2 (in FIG 10 ist die Rückseite die Oberseite wie in den anderen Figuren 2 bis 9 und 11) umfasst insbesondere das teilweise Entfernen der rückseitigen Passivierungsschicht 11 und auch das teilweise Entfernen der Leiterbahn 10 sowie der Barriereschicht 9.

In FIG 11 ist eine schematische Darstellung des Schritts zum Aufbringen eines Kontaktelements 12 auf der Rückseite des Halbleitersubstrats 2 im Rahmen des Verfahrens zur Herstellung einer Durchkontaktierung in einem Halbleiterbauelement 1 gemäß einem Ausführungsbeispiel der Erfindung veranschaulicht. Das Kontaktelement 12 kann als sogenanntes Lötpad ausgeführt sein und als Material Gold aufweisen. Weiterhin wird auch eine zweite rückseitige Passivierungsschicht 13 auf der Rückseite des Halbleitersubstrats 2 aufgebracht, um die Leiterbahn 10 vor Korrosion zu schützen. Das Kontaktelement 12 kann über einen sogenannten Lötball LB (siehe FIG 1) mit den Sensoren 1a (siehe FIG 1) elektrisch verbunden werden.

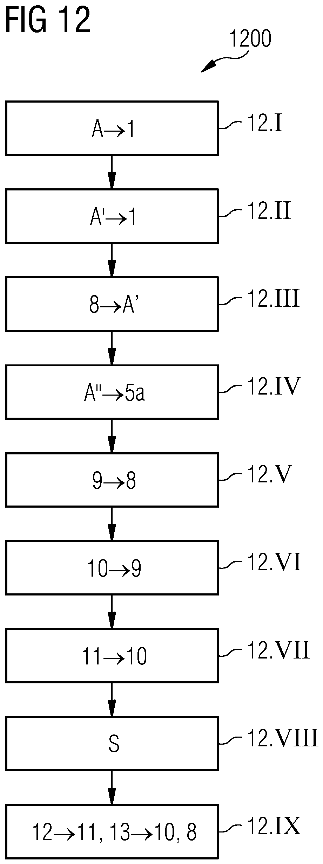

In FIG 12 ist ein Flussdiagramm 1200 gezeigt, welches ein Verfahren zur Herstellung einer Durchkontaktierung in einem Halbleiterbauelement 1 gemäß einem Ausführungsbeispiel der Erfindung veranschaulicht.

Bei dem Schritt 12.1 wird zunächst der in FIG 3 bereits veranschaulichte Ätzschritt durchgeführt, bei dem eine sacklochartige Aussparung A durch das Halbleitersubstrat 2 des Halbleiterbauelements 1 bis zur ersten elektrischen Isolationsschicht 3 ausgebildet wird.

Bei dem Schritt 12.II wird die erste elektrische Isolationsschicht 3 innerhalb der sacklochartigen Aussparung A entfernt und es wird die Aussparung A in vertikaler Richtung in Richtung einer Barriereschicht 5a einer Kontaktfläche 5 durch Anätzen der zweiten elektrischen Isolationsschicht 4 hin erweitert, ohne die Barriereschicht 5a zu erreichen, wobei eine vertiefte Aussparung A' entsteht, wie es bereits in FIG 4 graphisch veranschaulicht ist.

Bei dem Schritt 12.III wird eine dritte elektrische Isolationsschicht 8 auf Innenwänden der erweiterten bzw. vertieften Aussparung A' aufgebracht, wobei die erste elektrische Isolationsschicht 3 zu der erweiterten Aussparung A' hin abgedeckt wird. Der Schritt 12.III ist bereits in FIG 5 bildlich dargestellt.

Bei dem Schritt 12.IV wird die zweite elektrische Isolationsschicht 4 in dem Bereich der vertieften Aussparung A' anisotrop vertikal geätzt, bis die Barriereschicht 5a des Landing-Pads 5 bzw. der Kontaktfläche 5 über dem Testkontakt 6 freigelegt ist und die Aussparung A" für die Durchkontaktierung vollständig ausgebildet ist, was bereits in FIG 6 gezeigt ist.

Bei dem Schritt 12.V wird eine Barriereschicht 9 auf der Oberfläche der dritten elektrischen Isolationsschicht 8 und auf dem Testkontakt 6 in der Aussparung A" aufgebracht. Dieser Schritt ist bereits in FIG 7 gezeigt.

Bei dem Schritt 12.VI wird eine Leiterbahn 10 auf dem Halbleitersubstrat 2 und in der Aussparung A" auf der Barriereschicht aufgebracht. Dieser Schritt ist in FIG 8 graphisch veranschaulicht.

Bei dem Schritt 12.VII wird eine erste rückseitige Passivierungsschicht 11 auf der Leiterbahn 10 aufgebracht. Dieser Schritt ist bereits in FIG 9 bildlich dargestellt.

Bei dem Schritt 12.VIII wird eine Strukturierung S auf der Rückseite des Halbleitersubstrats 2 vorgenommen. Diese Strukturierung S ist in FIG 10 auf der Rückseite des Halbleitersubstrats 2 (dort als Oberseite dargestellt) zu erkennen.

Bei dem Schritt 12.IX werden Kontaktelemente 12 auf der Rückseite des Halbleitersubstrats 2 aufgebracht und es wird eine rückseitige Passivierungsschicht 13 auf der Rückseite des Halbleitersubstrats 2 aufgebracht.

Es wird abschließend noch einmal darauf hingewiesen, dass es sich bei den zuvor beschriebenen detaillierten Verfahren und Vorrichtungen um Ausführungsbeispiele handelt und dass das Grundprinzip auch in weiten Bereichen vom Fachmann variiert werden kann, ohne den Bereich der Erfindung zu verlassen, soweit er durch die Ansprüche vorgegeben ist. Es wird der Vollständigkeit halber auch darauf hingewiesen, dass die Verwendung der unbestimmten Artikel "ein" bzw. "eine" nicht ausschließt, dass die betreffenden Merkmale auch mehrfach vorhanden sein können. Ebenso schließt der Begriff "Einheit" nicht aus, dass diese aus mehreren Komponenten besteht, die gegebenenfalls auch räumlich verteilt sein können. Unabhängig vom grammatikalischen Geschlecht eines bestimmten Begriffes sind Personen mit männlicher, weiblicher oder anderer Geschlechteridentität mit umfasst.

## Patentansprüche

1. Verfahren zur Herstellung einer Aussparung (A") für eine Durchkontaktierung in einem Halbleiterbauelement (1), welches Halbleiterbauelement (1) aufweist:
- ein Halbleitersubstrat (2) mit einer Rückseite und einer Vorderseite,
- eine erste elektrische Isolationsschicht (3) auf der Vorderseite des Halbleitersubstrats (2),
- eine zweite elektrische Isolationsschicht (4) auf der ersten elektrischen Isolationsschicht (3),
- eine Kontaktfläche (5) für das Halbleitersubstrat (5) in oder an der zweiten elektrischen Isolationsschicht (4),
wobei das Verfahren die Schritte aufweist:
- Erstellen einer sacklochartigen Aussparung (A) durch das Halbleitersubstrat (2) bis zur ersten elektrischen Isolationsschicht (3),
- Entfernen der ersten elektrischen Isolationsschicht (3) innerhalb der sacklochartigen Aussparung (A),
- Erweitern der sacklochartigen Aussparung (A) in Richtung zu der Kontaktfläche (5) hin durch teilweises Entfernen der zweiten elektrischen Isolationsschicht (4),
- Aufbringen einer dritten elektrischen Isolationsschicht (8) auf Innenwänden der erweiterten Aussparung (A'), wobei die erste elektrische Isolationsschicht (3) zu der erweiterten Aussparung (A') hin abgedeckt wird,
- Anisotropes Ätzen der zweiten elektrischen Isolationsschicht (4) in Richtung auf die Kontaktfläche (5) hin, bis die Kontaktfläche (5) zum Halbleitersubstrat (2) hin freigelegt ist.

2. Verfahren nach Anspruch 1, wobei die erste elektrische Isolationsschicht (3) Siliziumnitrid umfasst und die zweite und die dritte elektrische Isolationsschicht (4, 8) Siliziumdioxid umfassen.

3. Verfahren nach Anspruch 1 oder 2, wobei das Erstellen einer sacklochartigen Aussparung (A) einen Ätzschritt umfasst.

4. Verfahren nach einem der Ansprüche 1 bis 3, wobei das teilweise Entfernen der zweiten elektrischen Isolationsschicht (4) ein Anätzen der zweiten elektrischen Isolationsschicht (4) umfasst.

5. Verfahren zur Herstellung einer Durchkontaktierung in einem Halbleiterbauelement (1), aufweisend die Schritte:
- Durchführen des Verfahrens nach einem der vorstehenden Ansprüche,
- Aufbringen einer Barriereschicht (9) auf einer von der ersten elektrischen Isolationsschicht (3) wegweisenden Oberfläche der dritten elektrischen Isolationsschicht (8) und auf der Kontaktfläche (5) in der Aussparung (A"),
- Aufbringen einer Leiterbahn (10) auf dem Halbleitersubstrat (2) und in der Aussparung (A") auf der Barriereschicht (9),
- Aufbringen einer ersten rückseitigen Passivierungsschicht (11) auf der Leiterbahn (10),
- Aufbringen eines Kontaktelementes (12) auf der Leiterbahn (10) .

6. Verfahren nach Anspruch 5, wobei die Leiterbahn (10) eines der folgenden Materialien aufweist:
- Kupfer,
- Aluminium,
- Wolfram.

7. Verfahren nach Anspruch 5 oder 6, wobei die erste rückseitige Passivierungsschicht (11) eines der folgenden Materialien aufweist:
- Nickel,
- Siliziumdioxid,
- Platin
und/oder wobei das Kontaktelement (12) als Material Gold aufweist.

8. Verfahren nach einem der Ansprüche 5 bis 7, wobei die Rückseite des Halbleitersubstrats (2) strukturiert wird und mit einer zweiten rückseitigen Passivierungsschicht (13) auf der dritten elektrischen Isolationsschicht (8) und auf der Leiterbahn (10) versehen wird.

9. Verfahren nach Anspruch 8, wobei die zweite rückseitige Passivierungsschicht (13) eines der folgenden Materialien umfasst:
- Polyimid,
- Siliziumnitrid,
- Siliziumdioxid.

10. Verfahren nach einem der vorangehenden Ansprüche, wobei das Halbleiterbauelement (1) außerdem einen Testkontakt (6) in Kontakt mit der Kontaktfläche (5) aufweist.

11. Verfahren nach Anspruch 10, wobei der Testkontakt (6) überlappend mit der flächigen Ausdehnung der Kontaktfläche (5) angeordnet ist.

12. Verfahren nach Anspruch 10 oder 11, wobei der Testkontakt (6) eine insgesamte Materialstärke aufweist, welche größer ist als die Materialstärke der Kontaktfläche (5).

13. Halbleiterbauelement (1), aufweisend:
- ein Halbleitersubstrat (2) mit einer Rückseite und einer Vorderseite,
- eine erste elektrische Isolationsschicht (3) auf der Vorderseite des Halbleitersubstrats (2),
- eine zweite elektrische Isolationsschicht (4) auf der ersten elektrischen Isolationsschicht (3),
- eine Kontaktfläche (5) für das Halbleitersubstrat (2) in oder an der zweiten elektrischen Isolationsschicht (4),
- eine Aussparung (A'') für eine Durchkontaktierung zwischen dem Halbleitersubstrat (2) und der Kontaktfläche (5),
wobei die Aussparung (A") bis zu der Kontaktfläche (5) hinreicht und eine dritte elektrische Isolationsschicht (8) auf Innenwänden der Aussparung (A'') ausgebildet ist, wobei die erste elektrische Isolationsschicht (3) zu der Aussparung (A") hin durch die dritte elektrische Isolationsschicht (8) abgedeckt ist.

14. Halbleiterbauelement nach Anspruch 13, ferner aufweisend:
- eine Barriereschicht (9) auf einer von der ersten elektrischen Isolationsschicht (3) wegweisenden Oberfläche der dritten elektrischen Isolationsschicht (8) und auf der Kontaktfläche (5) in der Aussparung (A"),
- eine Leiterbahn (10) auf dem Halbleitersubstrat (2) und in der Aussparung (A") auf der Barriereschicht (9),
- eine erste rückseitige Passivierungsschicht (11) auf der Leiterbahn (10),
- ein Kontaktelement (12) auf der ersten rückseitigen Passivierungsschicht (11).

15. Halbleiterbauelement nach Anspruch 14, aufweisend:
- eine strukturierte Rückseite des Halbleitersubstrats (2),
- eine zweite rückseitige Passivierungsschicht (13) auf der dritten elektrischen Isolationsschicht (8) und auf der Leiterbahn (10).

16. Röntgendetektormodul (15), aufweisend:
- eine Sensoreinheit (30),
- ein Halbleiterbauelement (1) nach einem der Ansprüche 13 bis 15, wobei das Halbleitersubstrat (2) des Halbleiterbauelements (1) eine Zählelektronik (20) aufweist, welche mit dem Halbleiterbauelement (1) elektrisch verbunden ist,
- eine Verteilungseinheit (40), welche mit dem Halbleiterbauelement (1) elektrisch verbunden ist,
- eine Auswertungseinheit (50), welche mit der Verteilungseinheit (40) elektrisch verbunden ist.

17. Computerprogrammprodukt mit einem Computerprogramm, welches direkt in eine Steuereinrichtung einer Halbleiterproduktionseinrichtung ladbar ist, mit Programmcodeabschnitten, um alle Schritte eines Verfahrens nach einem der Ansprüche 1 bis 12 auszuführen, wenn das Programm in der Steuereinrichtung ausgeführt wird.

18. Computerlesbares Medium, auf welchem von einer Rechnereinheit ausführbare Programmabschnitte gespeichert sind, um die Schritte eines Verfahrens nach einem der Ansprüche 1 bis 12 auszuführen, wenn die Programmabschnitte von der Rechnereinheit ausgeführt werden.
